# FASCICULE DE BREVET EUROPEEN

(11) **EP 2 401 186 B1**
(45) Date de publication et mention de la délivrance du brevet: **10.07.2019**
(21) Numéro de dépôt: 10712367.1
(22) Date de dépôt: 17.02.2010
(51) Int. Cl.: B61C 17/04, B61D 17/08, H05K 7/20

(54) **ENSEMBLE D'UNE PAROI ET D'UN ÉQUIPEMENT ÉLECTRIQUE ET VÉHICULE FERROVIAIRE CORRESPONDANT**
GRUPPE EINER FAHRZEUGWAND UND EINER ELEKTRISCHEN EINRICHTUNG, UND SCHIENENFAHRZEUG MIT DER GLEICHEN.
ASSEMBLY OF A WALL AND AN ELETRICAL COMPONENT, AND RAILWAY VEHICLE COMPRISING THE SAME

(30) Priorité: 26.02.2009 FR 0951217
(43) Date de publication de la demande: 04.01.2012
(73) Titulaire: ALSTOM Transport Technologies, 93400 Saint-Ouen (FR)
(72) Inventeur: BEKEMANS, Marc, B-6120 Nalinnes (BE); BOU SAADA, Jhonny, B-1330 Rixensart (BE)
(74) Mandataire: Lavoix
(86) Numéro de dépôt international: PCT/EP2010/051959
(87) Numéro de publication internationale: WO 2010/097317

(56) Documents cités:
- EP-A- 0 467 151
- DE-A1- 4 428 955
- DE-A1- 19 606 792
- FR-A- 2 806 364

## Description

La présente invention concerne un ensemble d'une paroi d'un véhicule ferroviaire et d'au moins un équipement électrique.

Elle concerne également un véhicule ferroviaire correspondant.

L'invention concerne plus particulièrement le domaine des équipements électriques de puissance embarqués dans les trains notamment les convertisseurs de puissance auxiliaires.

De tels équipements comportent habituellement une pluralité de composants électriques qui nécessitent d'être refroidis pour fonctionner correctement.

Ces équipements électriques comportent donc généralement un ou plusieurs échangeurs de chaleur ci-après dénommés refroidisseurs. Ces refroidisseurs sont généralement disposés dans un conduit définissant une direction de circulation principale d'un fluide de refroidissement des composants.

Les équipements électriques de puissance, notamment les convertisseurs auxiliaires, sont placés sur le toit ou sous le plancher du train. Pour les convertisseurs de traction qui pilotent les moteurs, la puissance dissipée est en relation directe avec le mouvement du train. Ces convertisseurs sont donc parfois refroidis simplement par la circulation de l'air produit par le déplacement du train. On parle alors de refroidissement par « vent vitesse ». Le refroidissement par « vent vitesse » convient difficilement aux convertisseurs auxiliaires car ils doivent fournir une pleine puissance y compris à l'arrêt.

Actuellement, les convertisseurs auxiliaires utilisent des ventilateurs qui poussent l'air dans des canaux de ventilation pour assurer le refroidissement par circulation d'air des composants électriques. L'utilisation de ces ventilateurs est actuellement indispensable, si l'on souhaite fonctionner à l'arrêt en pleine puissance. Le document EP0467151A prévoit ainsi de fixer, sur la paroi extérieure d'un camion, un boîtier renfermant les composants de puissance montés sur des plaques métalliques. De l'air est forcé par un ventilateur entre les plaques entre un orifice supérieur et un orifice inférieur.

Cependant, la présence des ventilateurs dans ces équipements les rend plus volumineux et très bruyants.

Le but de l'invention est d'offrir un équipement électrique de puissance qui soit compact et silencieux.

Plus particulièrement, l'invention vise à s'affranchir de l'utilisation des ventilateurs pour le refroidissement des composants des équipements électriques de puissance embarqués dans un train ou à utiliser des ventilateurs de moindre puissance.

A cet effet, l'invention a pour objet un véhicule ferroviaire selon la revendication 1. Suivant des modes particuliers de réalisation, le véhicule ferroviaire comporte l'une ou plusieurs des caractéristiques suivantes :
- le conduit est cloisonné en une pluralité de sous-conduits séparés entre eux par des moyens d'isolation thermique et électromagnétique ;
- un premier sous-conduit comporte des refroidisseurs fonctionnant à des températures comprises entre 50°C et 80°C ;
- un deuxième sous-conduit comporte des refroidisseurs fonctionnant à des températures supérieures à 80°C ;
- le compartiment est cloisonné en une pluralité de sous-compartiments séparés entre eux par des moyens d'isolation thermique et électromagnétique ;
- un premier sous-compartiment comporte des composants électriques fonctionnant à des températures inférieures à 125 °C ;
- un deuxième sous-compartiment comporte des composants électriques fonctionnant à des températures supérieures à 125°C ; et
- l'équipement électrique est un convertisseur de puissance auxiliaire ;
- l'équipement électrique possède une fréquence de découpe supérieure à 10 kHz;
- le fluide de refroidissement étant de l'air, le compartiment comporte à son extrémité inférieure une entrée d'air et à son extrémité supérieure une sortie d'air, l'entrée et la sortie d'air étant situées à l'intérieur du véhicule ;
- le conduit comporte des moyens de déflexion de l'air placés devant la première entrée d'air et la première sortie d'air ; et
- le compartiment et le conduit débouchant respectivement à l'intérieur et à l'extérieur du véhicule sont adjacents et séparés par une paroi d'isolation.

Ainsi, l'invention permet de pallier les inconvénients des équipements électriques actuels en fournissant un refroidissement naturel, par circulation d'air, des composants efficace même lorsque le train est à l'arrêt.

La solution proposée par l'invention évite les problèmes de volume et de bruit des équipements électriques dus à l'utilisation des ventilateurs pour le refroidissement.

On va maintenant décrire des exemples de réalisation de l'invention de façon plus précise, mais non limitative, en regard des dessins annexés sur lesquels :
- la figure 1 est une vue en perspective de la coupe d'un véhicule ferroviaire,
- la figure 2 est une vue en coupe verticale de l'équipement électrique selon l'invention, et
- la figure 3 est une vue en perspective et en coupe horizontale de l'équipement électrique selon un mode de réalisation de l'invention.

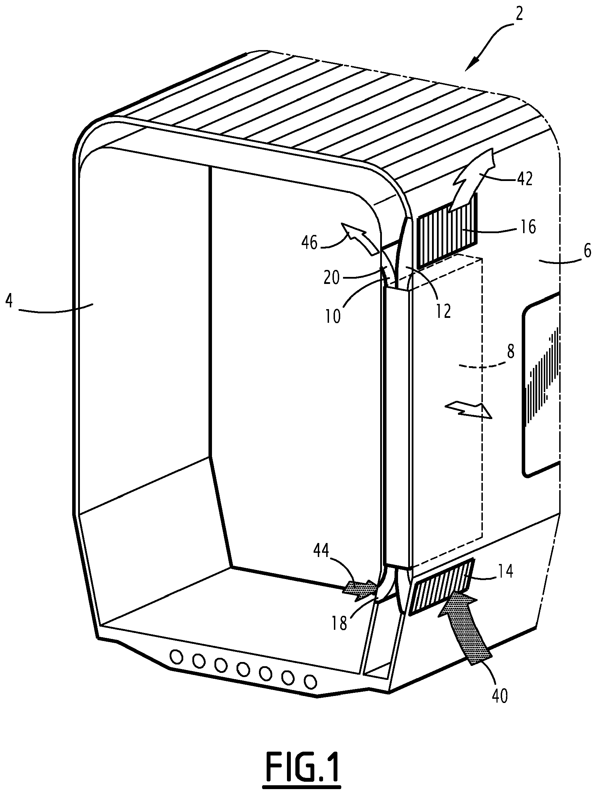

On a illustré sur la figure 1 un véhicule ferroviaire 2 comprenant deux parois latérales verticales 4 et 6 s'étendant parallèlement à la direction d'avancement du véhicule. Le véhicule est fermé à ses extrémités par des cloisons transversales.

Un équipement électrique 8, à titre d'exemple un convertisseur auxiliaire, est positionné dans la paroi 6.

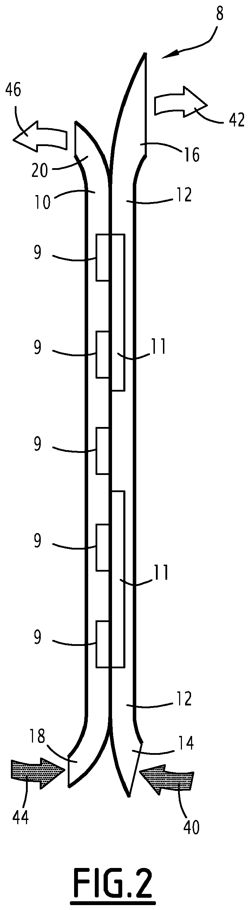

Cet équipement électrique 8, représenté sur la figure 2, comprend des composants électriques 9 répartis dans un compartiment 10 et un ou plusieurs refroidisseurs 11 placés dans un conduit 12.

Le conduit 12 comporte à son extrémité inférieure une première entrée d'air 14 et à son extrémité supérieure une première sortie d'air 16, la première entrée d'air 14 et la première sortie d'air 16 débouchant à l'extérieur du véhicule 2.

Le compartiment 10 comporte à son extrémité inférieure une deuxième entrée d'air 18 et à son extrémité supérieure une deuxième sortie d'air 20, la deuxième entrée d'air 18 et la deuxième sortie d'air 20 étant situées à l'intérieur du véhicule 2.

Selon l'invention, l'équipement électrique 8 est positionné verticalement dans la paroi 6 de sorte à définir une direction de circulation principale d'air dans le conduit 12 et le compartiment 10, verticale de bas en haut depuis l'entrée 14, 18 vers la sortie 16, 20 respectivement.

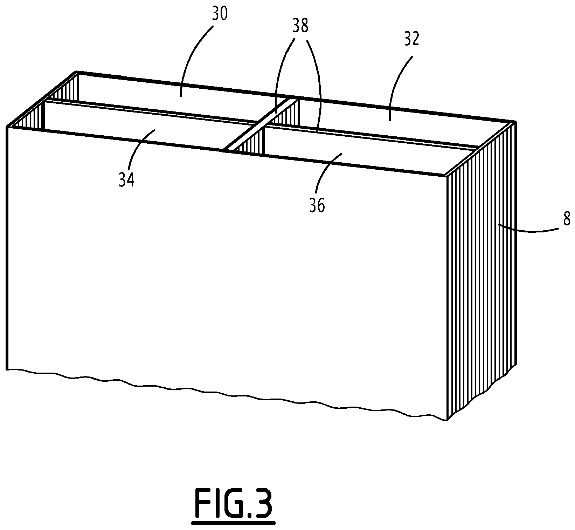

La figure 3 représente un mode de réalisation de l'équipement électrique 8 selon lequel cet équipement 8 contient une pluralité de zones séparées entre elles par des moyens d'isolation thermique et électromagnétique.

A titre d'exemple, l'équipement 8 contient quatre zones 30, 32, 34 et 36 séparées pas des moyens d'isolation 38 thermique et électromagnétique.

Les zones 30 et 32 sont obtenues suite à un cloisonnement vertical du conduit 12 et seront appelées sous-conduits dans la suite de la description.

Les zones 34 et 36 sont obtenues suite à un cloisonnement vertical du compartiment 10 et seront appelées sous-compartiments dans la suite de la description.

Le premier sous-conduit 30 comporte des refroidisseurs fonctionnant à des températures comprises entre 50°C et 80°C.

Le deuxième sous-conduit 32 comporte des refroidisseurs fonctionnant à des températures supérieures à 80 °C.

Ainsi, les sous-conduits 30 et 32 forment respectivement un canal de convection de température moyenne et un canal de convection de température élevée, les deux canaux étant isolés thermiquement.

En outre, le premier sous-compartiment 34 comporte des composants électriques sensibles aux perturbations électromagnétiques et ne supportant pas des températures supérieures à 125°C. Le deuxième sous -compartiment 36 comporte des composants électriques supportant des températures supérieures à 125°C. Ce deuxième sous-compartiment 36 constitue une zone à émission électromagnétique élevée et comporte ainsi des composants de commutation de puissance.

La structure de l'équipement électrique 8 selon l'invention ayant été décrite, la suite de la description concerne le fonctionnement du procédé de refroidissement des composants électriques 9 en référence aux figures 1 et 2.

Ainsi, de l'air frais de l'extérieur du train entre (flèche 40) au niveau de la première entrée d'air 14 à l'extrémité inférieure du conduit 12. Cet air refroidit les refroidisseurs 11 de l'équipement 8 situés dans le conduit 12 entraînant ainsi un refroidissement des composants 9 par un effet de conduction thermique. Au fur et à mesure qu'il se réchauffe, cet air monte en raison de la diminution de sa densité. Cet air sort (flèche 42) ensuite tiède ou chaud de la première sortie d'air 16 du conduit 12 vers l'extérieur du train.

Selon un mode de réalisation de l'invention, des systèmes d'écopage ou de déflexion de l'air (non représentés) sont placés devant la première entrée d'air 14 et la première sortie d'air 16 afin de favoriser le passage de l'air dans le conduit 12 quand le train roule.

En outre, de l'air frais de l'intérieur du train entre (flèche 44) au niveau de la deuxième entrée d'air 18 à l'extrémité inférieure du compartiment 10. Cet air refroidit les composants 9 de l'équipement 8 situés dans le compartiment 10. Au fur et à mesure qu'il se réchauffe, cet air monte en raison de la diminution de sa densité. Cet air sort (flèche 46) ensuite tiède ou chaud de la deuxième sortie d'air 20 du compartiment 10 vers l'intérieur du train.

Cette disposition verticale de la direction de circulation d'air dans le conduit 12 et le compartiment 10 permet d'avoir un effet de cheminée permettant un refroidissement naturel des composants électriques 9 de l'équipement 8 en produisant un tirage naturel généré par la différence de pression entre le haut et le bas de l'équipement du à l'échauffement de la colonne d'air emprisonnée.

Cette disposition verticale de la direction de circulation d'air, obtenue par la disposition verticale de l'équipement 8 dans la paroi 6, permet d'utiliser ce phénomène thermique naturel d'effet de cheminée pour refroidir les composants électriques 9, même lorsque le train est à l'arrêt sans nécessiter l'utilisation de ventilateurs puissants.

En outre, cette disposition verticale de l'équipement 8 dans la paroi est facilitée par le fait qu'en supprimant autant que possible les ventilateurs, l'équipement 8 est plus fin de sorte à pouvoir être intégré dans la paroi 6. De plus, la caisse du train participe à la réalisation de la structure mécanique de l'équipement 8 ce qui permet encore de réduire la masse de cet équipement.

Ainsi, l'invention permet d'avoir un équipement électrique compact et peu bruyant, du fait de la minimisation de l'utilisation de ventilateurs et de l'exploitation de l'effet de cheminée.

De plus, la disposition de l'équipement 8 dans la paroi 6 permet des échanges thermiques entre l'intérieur du train et l'équipement 8. Ainsi, d'un côté, le train refroidit les composants électriques 9 de l'équipement 8 situés dans le compartiment 10 par son air intérieur frais entrant par la deuxième entrée d'air 18. D'un autre côté, l'équipement 8 réchauffe le train par les pertes de chaleur évacuées sortant par la deuxième sortie d'air 20.

Ainsi, lorsque la température extérieure au train est élevée, par exemple l'été, l'air conditionné du véhicule ferroviaire climatisé permet un meilleur refroidissement des composants électriques critiques situés dans le compartiment 10, sans perturber de façon significative la puissance de climatisation installée.

Par contre, lorsque la température extérieure au train est basse, par exemple l'hiver, les pertes de chaleur évacuées par l'équipement 8 sont en partie récupérées à l'intérieur du véhicule ferroviaire permettent un meilleur réchauffement du train.

Dans les deux situations été ou hiver, l'échange autorisé entre l'air interne du train et les composants électriques 9 favorise la stabilité de la température des composants électrique 9.

La répartition des composants 9 et des refroidisseurs 11 de l'équipement électrique 8 en une pluralité de zones selon le mode de réalisation de la figure 3 permet d'isoler thermiquement le canal d'air chaud, ce qui améliore l'efficacité de l'effet de cheminée.

De plus, selon un mode particulier de réalisation de l'invention, les composants électriques 9 sont choisis pour résister à des températures élevées supérieures à une centaine de degrés, ce qui permet de s'affranchir d'autant plus de la nécessité d'utiliser des ventilateurs pour leur refroidissement.

Par ailleurs, selon un autre mode de réalisation de l'invention, l'équipement électrique 8 possède une fréquence de découpe élevée supérieure à 10 kHz, de sorte qu'il ne génère aucun bruit audible par l'oreille humaine.

Selon un autre aspect de l'invention, il est prévu des moyens de transport calorifique par un fluide caloporteur des composants 9 vers les refroidisseurs 11 permettant ainsi d'étaler les pertes de puissance dans l'équipement électrique 8.

Selon un autre aspect de l'invention, l'équipement électrique 8 est intégré dans une cloison de séparation entre véhicules et non dans une paroi latérale permettant ainsi d'éviter l'utilisation de l'espace généralement nécessaire pour le placement des fenêtres dans les véhicules de transport de voyageurs.

Bien entendu, d'autres modes de réalisation encore peuvent être envisagés.

## Revendications

1. Véhicule ferroviaire (2) comprenant des parois latérales et des cloisons transversales externes et au moins un équipement électrique (8) intégré dans l'une des parois latérales ou l'une des cloisons transversales, l'équipement électrique (8) comprenant une pluralité de composants électriques (9) disposés dans au moins un compartiment (10) et au moins un refroidisseur (11) disposé dans au moins un conduit (12) définissant une direction de circulation principale d'un fluide de refroidissement des composants (9), l'équipement électrique (8) étant positionné de sorte que la direction de circulation soit disposée verticalement, et, le fluide de refroidissement étant de l'air, le conduit (12) comportant à son extrémité inférieure une entrée d'air (14) et à son extrémité supérieure une sortie d'air (16), l'entrée et la sortie d'air étant situées à l'extérieur du véhicule.

2. Véhicule selon la revendication 1, **caractérisé en ce que** le fluide de refroidissement étant de l'air, le compartiment (10) comporte à son extrémité inférieure une entrée d'air (18) et a son extrémité supérieure une sortie d'air (20), l'entrée et la sortie d'air étant situées à l'intérieur du véhicule.

3. Véhicule selon la revendication 1 ou la revendication 2, **caractérisé en ce que** le conduit (12) comporte des moyens de déflexion de l'air placés devant la première entrée d'air (14) et la première sortie d'air (16).

4. Véhicule selon l'une quelconque des revendications 1 à 3, **caractérisé en ce que** le compartiment (10) et le conduit (12) débouchant respectivement à l'intérieur et à l'extérieur du véhicule sont adjacents et sépares par une paroi d'isolation (38).

5. Véhicule selon l'une quelconque des revendications 1 à 4, **caractérisé en ce que** le conduit (12) est cloisonné en une pluralité de sous-conduits (30, 32,) séparés entre eux par des moyens d'isolation thermique et électromagnétique (38).

6. Véhicule selon la revendication 5, **caractérisé en ce que** :
- un premier sous-conduit (30) comporte des refroidisseurs fonctionnant à des températures comprises entre 50°C et 80°C ;
- un deuxième sous-conduit (32) comporte des refroidisseurs fonctionnant a des températures supérieures à 80°C.

7. Véhicule selon l'une quelconque des revendications 1 à 6, **caractérisé en ce que** le compartiment (10) est cloisonné en une pluralité de sous-compartiments (34, 36) séparés entre eux par des moyens d'isolation thermique et électromagnétique (38).

8. Véhicule selon la revendication 7, **caractérisé en ce que** :
- un premier sous-compartiment (34) comporte des composants électriques fonctionnant à des températures inférieures â 125°C ;
- un deuxième sous-compartiment (36) comporte des composants électriques fonctionnant à des températures supérieures à 125°C.

9. Véhicule selon l'une quelconque des revendications 1 à 5, **caractérisé en ce que** l'équipement électrique (8) est un convertisseur de puissance auxiliaire.

10. Véhicule selon l'une quelconque des revendications 1 à 6, **caractérisé en ce que** l'équipement électrique (8) possède une fréquence de découpe supérieure à 10 kHz.

## Patentansprüche

1. Schienenfahrzeug (2), das Seitenwände und äußere Quertrennwände und mindestens eine elektrische Ausrüstung (8) aufweist, die in eine der Seitenwände oder eine der Quertrennwände integriert ist, wobei die elektrische Ausrüstung (8) eine Mehrzahl von elektrischen Komponenten (9), die in mindestens einer Kammer (10) angeordnet sind, und mindestens eine Kühlvorrichtung (11), die in mindestens einem Kanal (12) angeordnet ist, der eine Hauptrichtung zur Zirkulation eines Fluids zur Kühlung der Komponenten (9) definiert, aufweist, wobei die elektrische Ausrüstung (8) derart positioniert ist, dass die Zirkulationsrichtung vertikal angeordnet ist, und das Kühlfluid Luft ist, wobei der Kanal (12) an seinem unteren Ende einen Lufteinlass (14) und an seinem oberen Ende einen Luftauslass (16) aufweist, wobei der Lufteinlass und -auslass außerhalb des Fahrzeugs angeordnet sind.

2. Fahrzeug nach Anspruch 1, **dadurch gekennzeichnet, dass**, wenn das Kühlfluid Luft ist, weist die Kammer (10) an ihrem unteren Ende einen Lufteinlass (18) und an ihrem oberen Ende einen Luftauslass (20) auf, wobei der Lufteinlass und -auslass innerhalb des Fahrzeugs angeordnet sind.

3. Fahrzeug nach Anspruch 1 oder Anspruch 2, **dadurch gekennzeichnet, dass** der Kanal (12) Mittel zum Ablenken der Luft aufweist, die vor dem ersten Lufteinlass (14) und dem ersten Luftauslass (16) liegen.

4. Fahrzeug nach einem beliebigen der Ansprüche 1-3, **dadurch gekennzeichnet, dass** die Kammer (10) und der Kanal (12), die jeweils im Inneren und außerhalb des Fahrzeugs münden, benachbart angeordnet und durch eine Isolierwand (38) getrennt sind.

5. Fahrzeug nach einem beliebigen der Ansprüche 1-4, **dadurch gekennzeichnet, dass** der Kanal (12) in eine Mehrzahl von Nebenkanälen (30, 32) aufgeteilt ist, die untereinander durch Mittel (38) zur thermischen und elektromagnetischen Isolierung getrennt sind.

6. Fahrzeug nach Anspruch 5, **dadurch gekennzeichnet, dass**:
- ein erster Nebenkanal (30) Kühler aufweist, die bei Temperaturen zwischen 50° C und 80° C arbeiten;
- ein zweiter Nebenkanal (32) Kühler aufweist, die bei Temperaturen größer als 80° C arbeiten.

7. Fahrzeug nach einem beliebigen der Ansprüche 1-6, **dadurch gekennzeichnet, dass** die Kammer (10) in eine Mehrzahl von Nebenkammern (34, 36) aufgeteilt ist, die untereinander durch Mittel (38) zur thermischen und elektromagnetischen Isolierung getrennt sind.

8. Fahrzeug nach Anspruch 7, **dadurch gekennzeichnet, dass**:
- eine erste Nebenkammer (34) elektrische Komponenten aufweist, die bei Temperaturen kleiner als 125° C arbeiten;
- eine zweite Nebenkammer (36), die elektrische Komponenten aufweist, die bei Temperaturen größer als 125° C arbeiten.

9. Fahrzeug nach einem beliebigen der Ansprüche 1-5, **dadurch gekennzeichnet, dass** die elektrische Ausrüstung (8) ein Hilfsstromwandler ist.

10. Fahrzeug nach einem beliebigen der Ansprüche 1-6, **dadurch gekennzeichnet, dass** die elektrische Ausrüstung (8) eine Schaltfrequenz größer als 10 kHz besitzt.

## Claims

1. Railway vehicle (2) comprising side walls and external transverse partitions and at least one piece of electrical equipment (8) integrated into one of the side walls or one of the transverse partitions, the piece of electrical equipment (8) comprising a plurality of electrical components (9) arranged in at least one compartment (10) and at least one cooler (11) arranged in at least one pipe (12) defining a main direction of flow of a cooling fluid for the components (9), the piece of electrical equipment (8) being positioned so that the direction of flow is arranged vertically and, the cooling fluid being air, the pipe (12) having at its lower end an air inlet (14) and at its upper end an air outlet (16), the air inlet and the air outlet being situated outside the vehicle.

2. Vehicle according to claim 1, **characterised in that**, the cooling fluid being air, the compartment (10) has at its lower end an air inlet (18) and at its upper end an air outlet (20), the air inlet and the air outlet being situated inside the vehicle.

3. Vehicle according to claim 1 or claim 2, **characterised in that** the pipe (12) has air deflection means placed in front of the first air inlet (14) and the first air outlet (16).

4. Vehicle according to any one of claims 1 to 3, **characterised in that** the compartment (10) and the pipe (12) opening inside and outside the vehicle, respectively, are adjacent and separated by an insulating wall (38).

5. Vehicle according to any one of claims 1 to 4, **characterised in that** the pipe (12) is partitioned into a plurality of sub-pipes (30, 32) which are separated from one another by thermal and electromagnetic insulating means (38).

6. Vehicle according to claim 5, **characterised in that**:
- a first sub-pipe (30) has coolers operating at temperatures between 50°C and 80°C;
- a second sub-pipe (32) has coolers operating at temperatures above 80°C.

7. Vehicle according to any one of claims 1 to 6, **characterised in that** the compartment (10) is partitioned into a plurality of sub-compartments (34, 36) which are separated from one another by thermal and electromagnetic insulating means (38).

8. Vehicle according to claim 7, **characterised in that**:
- a first sub-compartment (34) has electrical components operating at temperatures below 125°C;
- a second sub-compartment (36) has electrical components operating at temperatures above 125°C.

9. Vehicle according to any one of claims 1 to 5, **characterised in that** the piece of electrical equipment (8) is an auxiliary power converter.

10. Vehicle according to any one of claims 1 to 6, **characterised in that** the piece of electrical equipment (8) has a cut-off frequency greater than 10 kHz.
